# EUROPEAN PATENT SPECIFICATION

(11) **EP 2 391 581 B1**
(45) Date of publication and mention of the grant of the patent: **16.01.2013**
(21) Application number: 10701866.5
(22) Date of filing: 28.01.2010
(51) Int. Cl.: C01B 33/035, G01B 11/06, G01B 11/08, G01B 21/08, H01L 21/66, C23C 16/24, C23C 16/44, C23C 16/52

(54) **ARRANGEMENT AND METHOD FOR MEASUREMENT OF THE TEMPERATURE AND OF THE THICKNESS GROWTH OF SILICON RODS IN A SILICON DEPOSITION REACTOR**
ANORDNUNG UND VERFAHREN ZUR MESSUNG DER TEMPERATUR UND DES DICKENWACHSTUMS VON SILICIUMSTÄBEN IN EINEM SILICIUMABSCHEIDUNGSREAKTOR
AGENCEMENT ET PROCÉDÉ DE MESURE DE LA TEMPÉRATURE ET DE LA CROISSANCE EN ÉPAISSEUR DE BARREAUX DE SILICIUM DANS UN RÉACTEUR DE DÉPÔT DE SILICIUM

(30) Priority: 29.01.2009 DE 102009006600; 24.02.2009 DE 102009010086
(43) Date of publication of application: 07.12.2011
(73) Proprietor: centrotherm SiTec GmbH, 89143 Blaubeuren (DE)
(72) Inventor: WILFRIED, Vollmar, 59494 Soest - Deiringsen (DE); STUBHAN, Frank, 89584 Ehingen (DE)
(74) Representative: Lippert, Stachow & Partner
(86) International application number: PCT/EP2010/050988
(87) International publication number: WO 2010/086363

(56) References cited:
- EP-A2- 0 470 646
- AT-B- 222 184
- GB-A- 1 378 302
- GB-A- 2 159 272
- US-A- 2 981 605
- US-A- 4 125 643
- PATEL V ET AL: "WAFER TEMPERATURE MEASUREMENTS AND END-POINT DETECTION DURING PLASMA ETCHING BY THERMAL IMAGING" APPLIED PHYSICS LETTERS, AIP, AMERICAN INSTITUTE OF PHYSICS, MELVILLE, NY, US LNKD- DOI:10.1063/1.105480, vol. 59, no. 11, 9 September 1991 (1991-09-09), pages 1299-1301, XP000232852 ISSN: 0003-6951
- BOEBEL F G ET AL: "REAL TIME, IN SITU MEASUREMENT OF FILM THICKNESS WITH REFLEXION SUPPORTED PYROMETRIC INTERFEROMETRY (RSPI)" PROCEEDINGS OF THE ADVANCED SEMICONDUCTOR MANUFACTURING CONFERENCE AND WORKSHOP (ASMC). CAMBRIDGE, MA., NOV. 14 - 16, 1994; [PROCEEDINGS OF THE ADVANCED SEMICONDUCTOR MANUFACTURING CONFERENCE AND WORKSHOP (ASMC)], NEW YORK, IEEE, US LNKD- DOI:10.1109, 14 November 1994 (1994-11-14) , pages 311-315, XP000527231 ISBN: 978-0-7803-2054-3

## Description

The invention relates to an arrangement and a method for measurement of the temperature and of the thickness growth of silicon rods in a silicon deposition reactor through a viewing window.

The manufacturing process for polycrystalline silicon is based on a method in which gaseous trichlorosilane is passed together with hydrogen into a vacuum reactor in which thin silicon rods have previously been arranged as the raw material, and are electrically heated to temperatures of around 1100 degrees Celsius. This method has become known as the so-called SIEMENS method. In this case, strict attention must be paid to not reaching the melting temperature of silicon. In this case, silicon is deposited on the silicon rods, with the silicon being created in a chemical reaction from the trichlorosilane. The pillars of polysilicon which are created in this way are then available for further processing.

The pillars are once again broken down into relatively small chunks for the photovoltaic industry, and are then melted in quartz crucibles and, if required, are reshaped into monocrystalline or polycrystalline blocks, from which the blanks for solar modules are then manufactured.

One critical factor in this process is the temperature control of the thin silicon rods in the silicon deposition reactor during the coating process, during which the temperature must be kept within a predetermined temperature range around 1100°C, and it is absolutely essential to stop this process if over-temperatures occur, which would lead to fracture of a silicon rod and to stopping of the deposition process, and in the event of excessively low temperatures, which would not lead to optimum deposition of the silicon.

One possible way to comply with these conditions would be a continuous manual visual inspection, which would be extremely complex and would have to be carried out at least during the first hours of the process.

One or more viewing windows are located for this purpose in the silicon deposition reactor and allow observation with approximate values by manual viewing and personal estimation. This must be done all the time and, of course, does not lead to reproducible, sufficiently reliable results. This is because fatal consequences can result from the nominal temperature being briefly exceeded.

In PATEL V ET AL: "WAFER TEMPERATURE MEASUREMENTS AND END-POINT DETECTION DURING PLASMA ETCHING BY THERMAL IMAGING" APPLIED LETTERS, AIP, AMERICAN INSTITUTE OF PHYSICS, MELVILLE, NY, US LNKD-DOI: 10.1063/1.105480, vol. 59, no. 11, 9 September 1991 (10-09-09), pages 1299-1301, ISSN : 0003-6951 is described the use of an infrared television camera for realtime measurements of the wafer temperature during plasma etching and using these temperature measurements to determine the end-point as well as other critical parameters. A thin window is used for perpendicular viewing of a silicon wafer by the camera and a laser thickness monitor.

The AT 222 184 B (SIEMENS AG) 10 July 1962 (1962-07-10) discloses a process for manufacturing of semiconductor rods. An image from an glowing semiconductor rod is scanned through a viewing window with a movable photo cell during the growth of thickness in the silicon deposition reactor. The border between light and dark is detected by an contactless operating temperature measurement device and is used to amend the current of a heating circuit which is increased at such a manner that the temperature of the semiconductor rod is held on a given temperature.

From US 2 981 605 A (THEODOR RUMMEL) 25 April 1961 (1961-04-25) is known a method and apparatus for producing highly pure rodlike semiconductor bodies. The temperature of the bodiese is measured with a stationary pyrometer.

The GB 2 159 272 A (MANNESMANN AG) 27 November 1985 (1985-11-27) discloses an angularly pivoted optical pyrometer to measure the averaged-out temperature of a deposited film on a steel slab in a furnace.

In BOEBEL F G ET AL: "REAL TIME, IN SITU MEASUREMENT OF FILM THICKNESS WITH REFLEXION SUPPORTED PYROMETRIC INTERFEROMETRY (RSPI)" PROCEEDINGS OF THE ADVANCED SEMICONDUCTOR MANUFACTURING CONFERENCE AN WRKSHOP (ASMC), CAMBRIDGE, MA., NOV. 14 - 16, 1994; [PROCEEDINGS OF THE ADVANCED SEMICONDUCTOR MANUFACTURING CONFERENCE AND WORKSHOP (ASMC)], NEW YORK, IEEE, US LNKD- DOI: ISBN : 978-0-7803-2054-3 is disclosed the measurement of the temperature and thickness of a film using a stationary pyrometer using the radiation reflexion and complex interferometry calculations.

The GB 1 378 302 A (SIEMENS AG) 27 Decenber 1974 (1974-12-27) describes improvements in or relating to the production of semiconductor rods by use of a stationary optical pyrometer to mesure the temperature of the rods.

Finally the US 4 125 643 A (REUSCHEL KONRAD RT AL) 14 November 1978 (1978-11-14) describes a process for deposition elemtal silicon semiconductor material from a gas phase and uses a TV camera and its electrical signal to monitor the silicon rods during deposition.

The invention is based on the object of providing an arrangement and a method for measurement ofing the temperature and of the thickness growth of silicon rods in a silicon deposition reactor, in order to allow sufficiently accurate continuous measurement of the temperature and of the thickness growth throughout the entire deposition process.

The object on which the invention is based is achieved in that a contactless operating temperature measurementing device is provided for the temperature measurement and is arranged outside the silicon deposition reactor in front of a viewing window, in that the temperature measurementing device pivots horizontally about a rotation axis by means of a rotating drive, wherein the rotation axis runs parallel to the longitudinal axis of the silicon rod, and wherein the centre axis of the temperature measurementing device runs through the pivoting axis. The thermal radiation emerging from a silicon rod is measured during this process.

In one development of the invention, the rotation axis is located outside the reactor wall of the silicon deposition reactor, in front of the viewing window.

In one variant of the invention, the reaction axis is arranged within the silicon deposition reactor, behind the viewing window, thus making it possible to record a wider pivoting range in the silicon deposition reactor. Furthermore, the viewing window is cooled by being provided with liquid cooling. The corruption of the measurement temperature resulting from this can be corrected purely by calculation.

In one particular development, a rotatable polarization filter is arranged between the temperature measurement device and the viewing window, or at least in front of the temperature measurement device. This makes it possible to mask out or to minimize reflections on the inner wall of the silicon deposition reactor. This allows incorrect measurements to be avoided, thus improving the measurement accuracy.

In a further refinement of the invention, the temperature measurement device is a pyrometer whose measurement data is stored for further processing and is displayed on a monitor, wherein a grid can be superimposed on the data displayed on the monitor for better orientation.

The temperature measurement device may also be a thermal imaging camera which pivots where in the analysis of the measurement data, that is to say the temperature profile over time and the temperature profile over the angle, are evaluated electronically.

Furthermore, the temperature measurement device is coupled to a rotating drive for positioning of the rotation axis behind the sight glass, which rotating drive is located below a tubular connecting stub, which projects from the reactor wall and in which a sight glass is located.

The arrangement according to the invention can advantageously be used for silicon depositing reactors.

The object on which the invention is based is also achieved by a method for measurement of the temperature and of the thickness growth of thin silicon rods in a silicon deposition reactor, by
- arrangement of thin silicon rods in the silicon deposition reactor, removal of the oxygen and starting of the deposition process by integration of the thin silicon rods in an electrical circuit, and introduction of trichlorosilane in the silicon deposition reactor,
- scanning of the thin silicon rods by a temperature measurement device which is located outside the silicon deposition reactor, and selection of one of the thin silicon rods and focusing of the pyrometer onto the selected thin silicon rod,
- recording a temperature curve plotted against the time and simultaneous measurement of the thickness growth by horizontally pivoting the pyrometer until a sudden light/dark change is identified and pivoting the pyrometer in the opposite pivoting direction until a further sudden light/dark change is identified,
- calculation of the diameter of the coated thin silicon rod from the pivoting angle, and
- repetition of the measurement of the thickness growth at intervals, and ending the deposition process after the coated silicon rod has reached a predetermined thickness.

The intervals may in this case also be zero, that is to say measurements are carried out without any interruption, or they may assume discrete values, thus allowing measurements to be carried out at defined intervals.

A thin silicon rod which is located closest to the viewing window is preferably selected, after its integration into an electrical circuit.

In one particular refinement of the invention, any reflections which may be present on the inner wall of the silicon deposition reactor before the start of the scanning process are masked out by a polarization filter, in that this polarization filter is rotated until the reflections have disappeared, or have at least been reduced.

The arrangement according to the invention can advantageously be used for deposition reactors with thermally dependent layer growth.

The particular advantages of the invention are that the coating process can be carried out from the start with automatic temperature detection and thickness measurement, thus making it possible to avoid over-temperatures which would lead to the process being shut down. In addition, this makes it possible to avoid excessively low temperatures, which would lead to non-optimum layer deposition.

Furthermore, the coating process is optimized in that it can be ended when the silicon rods reach a nominal thickness. In addition, the use of media is optimized in that the gas processes can be controlled automatically with the rod diameter that is achieved, because correspondingly more trichlorosilane must be supplied as the thickness of the silicon rods increases, for constant thickness growth.

The arrangement according to the invention makes it possible to determine the deposition thickness and the layer thickness increase over time without any problems, to be precise using the considerable sudden temperature change on the external circumference of the silicon rod.

The invention will be explained in more detail in the following text with reference to one exemplary embodiment.

In the associated drawing figures
- Figure 1 :: shows a schematic plan view of an arrangement according to the invention for temperature measurement of silicon rods;
- Figure 2:: shows a schematic plan view of a variant as shown in Figure 1, in which the pivoting axis of the temperature measurement device is located behind the sight glass; and
- Figure 3:: shows a schematic plan view of the variant as shown in Figure 2, with a polarization filter added.

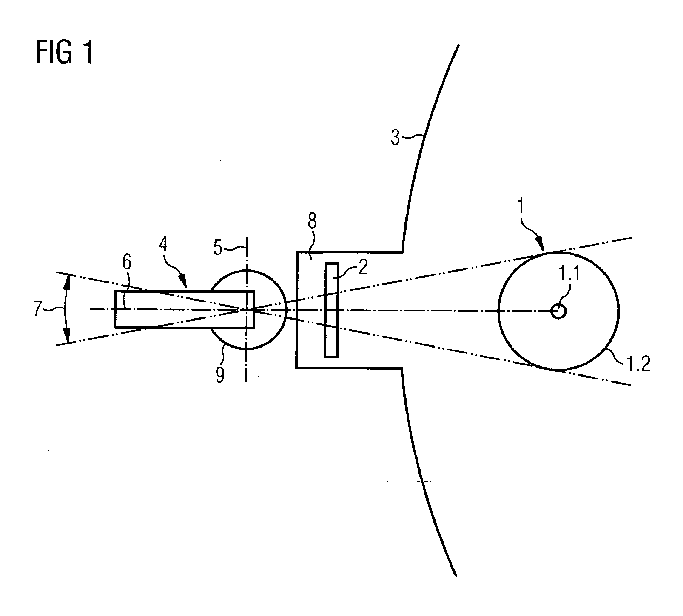

According to Figure 1, the arrangement for temperature measurement of silicon rods 1 in a silicon deposition reactor through a viewing window 2 in the reactor wall 3 contains a contactlessly operating temperature measurement device 4 which can be pivoted about a pivoting axis 5. The pivoting axis 5 runs parallel to the longitudinal axis 6 of the silicon rod 1. Furthermore, the longitudinal axis 6 of the temperature measurement device 4 runs through the pivoting axis 5.

Figure 1 shows the silicon rod 1 in two states, specifically as a thin silicon rod 1a and as a silicon rod 1b after the end of the process.

In the variant shown in Figure 1, the pivoting axis 5 is located outside the reactor wall 3 of the silicon deposition reactor, in front of the viewing window 2, which is accommodated in a tubular connecting stub 8 which projects out of the tube wall 3.

Motor adjustment in the form of a rotating drive 9 is provided for the pivoting drive for the temperature measurement device 4.

The arrangement according to the invention allows the silicon rod 1 to be scanned permanently or at time intervals in a simple manner during the deposition process, to be precise to determine the temperature and the thickness growth. Since scanning over the width of the silicon rod 1 is possible, the thickness growth of the silicon rod 1 can be continuously checked during the deposition process on the basis of the sudden temperature change at the side edge of the silicon rod 1.

Furthermore, this allows the use of media to be optimized, in that the gas processes can be automatically matched to the rod diameter that has been achieved, because correspondingly more trichlorosilane must be supplied as the thickness of the silicon rods increases, with constant thickness growth. The process can therefore be started with a minimal required amount of trichlorosilane, in which case the amount can then be matched to the increasing diameter of the silicon rod.

The achieved thickness can be calculated from the distance between the pivoting axis 5 and the silicon rod 1, and the determined pivoting angle.

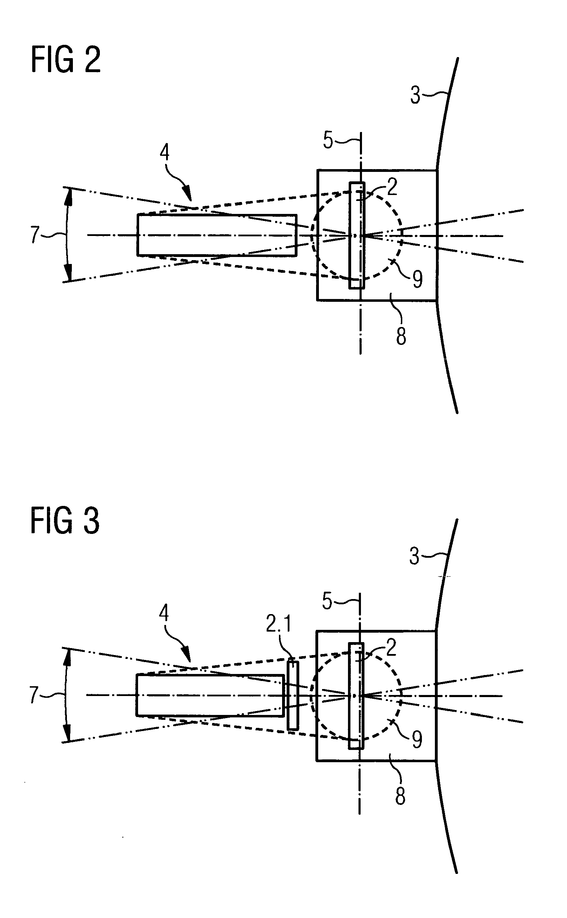

Figure 2 shows a schematic plan view of a variant of the invention in which the pivoting axis 5 is located behind the viewing window 2, that is to say within the silicon deposition reactor, thus making it possible to achieve a greater pivoting angle.

In order to position the pivoting axis 5 behind the sight glass, the temperature measurement device 4 is coupled to a rotating drive 9 which is located under the sight glass.

A pyrometer whose measurement data can be stored and displayed on a monitor is particularly suitable for use as the temperature measurement device 4, on which a grid can be superimposed in order to better illustrate the displayed data and limit values.

Instead of a pyrometer, a thermal imaging camera can also be used, and can also be arranged to be stationary if appropriately programmed.

Furthermore, a rotatable polarization filter 2.1 can be arranged between the pyrometer and the viewing window 2, thus making it possible to mask out disturbing reflections on the inner wall of the reactor, or at least to minimize them, by appropriately rotating the polarization filter 2.1 until the reflections disappear or are minimized (Figure 3). This makes it possible to achieve a particularly high measurement accuracy.

The arrangement according to the invention allows an automated method for measurement of the temperature and of the thickness growth of thin silicon rods in a silicon deposition reactor.

For this purpose, thin silicon rods 1.1 are first of all arranged in the silicon deposition reactor, and oxygen is removed from the silicon deposition reactor. The deposition process can then be started by integration of the thin silicon rods 1.1 in an electrical circuit, and introduction of trichlorosilane. The thin silicon rods 1.1 are heated electrically to a temperature of around 1100°C, that is to say the deposition temperature.

The thin silicon rods 1.1 are then scanned by a temperature measurement device 4, for example a pyrometer, which is located outside the silicon deposition reactor, and one of the thin silicon rods 1.1 is selected, with the pyrometer being, focused on this thin silicon rod 1.1.

A temperature curve is then recorded over time, and the simultaneous or subsequent measurement of the thickness growth of the thin silicon rods 1.1 is carried out by horizontally pivoting the temperature measurement device 4 until a sudden light/dark change is identified and pivoting the temperature measurement device 4 in the opposite pivoting direction until a further sudden light/dark change is identified. The diameter of the coated thin silicon rod 1.1 can then be calculated easily from the distance between the pivoting axis and the silicon rod, and the measured pivoting angle.

In order to improve the accuracy of the measurement process, reflections on the inner wall of the silicon deposition reactor before the start of the scanning process should be masked out and this can be done by means of a polarization filter, by rotating this polarization filter until the reflection has disappeared or has at least been reduced.

The thickness growth is measured either at uniform time intervals or continuously, such that the silicon deposition process is ended once the coated thin silicon rod 1.2 reaches a predetermined thickness.

In principle, of course, it is also possible to measure a plurality of thin silicon rods 1.1 staggered in time.

This method on the one hand ensures that a critical temperature is never exceeded, while on the other hand optimizes the deposition process by the capability to stop this process when the silicon rods reach the nominal thickness.

In principle, it is also possible to pivot the temperature measurement device 4 about a horizontal axis, which should preferably be located behind the viewing window. This makes it possible to mask out reflections from the opposite reactor wall, by pivoting the temperature measurement device 4 somewhat downwards or upwards.

Arrangement and method for measurement of the temperature and of the thickness growth of silicon rods in a silicon deposition reactor

### List of reference symbols

- 1: Silicon rod
- 1.1: Thin silicon rod
- 1.2: Silicon rod after the end of deposition
- 2: Viewing window
- 2.1: Polarization filter
- 3: Reactor wall
- 4: Temperature measurement device
- 5: Pivoting axis
- 6: Longitudinal axis
- 7: Rotation angle
- 8: Tubular connecting stub
- 9: Rotating drive

## Claims

1. Arrangement for measurement of the temperature and of the thickness growth of silicon rods in a silicon deposition reactor through a viewing window, **characterized in that** a contactless operating temperature measurement device (4) is provided for the temperature measurement and is arranged outside the silicon deposition reactor in front of a viewing window (2), **in that** the temperature measurement device (4) pivots horizontally about a pivoting axis (5) by means of a rotating drive (9), wherein the pivoting axis (5) runs parallel to the longitudinal axis of the silicon rod (1), and wherein the centre axis (6) of the temperature measurement device runs through the pivoting axis (5).

2. Arrangement according to Claim 1, **characterized in that** the pivoting axis (5) is arranged outside the reactor wall (3) of the silicon deposition reactor, in front of the viewing window (2).

3. Arrangement according to Claim 1, **characterized in that** the pivoting axis (5) is arranged within the silicon deposition reactor, behind the viewing window (2).

4. Arrangement according to one of Claims 1 to 3, **characterized in that** the viewing window (2) is cooled.

5. Arrangement according to Claim 4, **characterized in that** the viewing window (2) is provided with liquid cooling.

6. Arrangement according to one of Claims 1 to 5, **characterized in that** a rotatable polarization filter (2.1) is arranged between the temperature measurement device (4) and the viewing window (2).

7. Arrangement according to one of Claims 1 to 6, **characterized in that** the temperature measurement device (4) is a pyrometer.

8. Arrangement according to Claim 7, **characterized in that** the measurement data of the pyrometer is stored in a memory and is displayed on a monitor.

9. Arrangement according to Claim 8, **characterized in that** a grid is superimposed on the data displayed on the monitor.

10. Arrangement according to one of Claims 1 to 6, **characterized in that** the temperature measurement device (4) is a thermal imaging camera.

11. Arrangement according to one of Claims 1 to 10, **characterized in that** the temperature measurement device (4) is coupled to a rotating drive (9) behind the sight glass (2) in order to position the pivoting axis (5), which rotating drive (9) is located below the sight glass (2), wherein the sight glass (2) is arranged in a tubular connecting stub (8) located on the reactor wall (3).

12. Use of the arrangement according to one of Claims 1 to 10 for silicon deposition reactors.

13. Method for measurement of the temperature and of the thickness growth of thin silicon rods in a silicon deposition reactor, **characterized by**
- arrangement of thin silicon rods in the silicon deposition reactor, removal of the oxygen and starting of the deposition process by integration of the thin silicon rods (1.1) in an electrical circuit, and introduction of tricholorosilane,
- scanning of the thin silicon rods (1.1) by a temperature measurement device (4) which is located outside the silicon deposition reactor, and selection of one of the thin silicon rods (1.1) and focusing of the temperature measurement device onto the selected thin silicon rod (1.1),
- recording a temperature curve plotted against the time and simultaneous measurement of the thickness growth by horizontally pivoting the temperature measurement device (4) until a sudden light/dark change is identified and pivoting the temperature measurement device (4) in the opposite pivoting direction until a further sudden light/dark change is identified,
- calculation of the diameter of the coated thin silicon rod from the pivoting angle and the distance between the pivoting axis (5) and the silicon rod (1), and
- repetition of the measurement of the thickness growth at predetermined intervals, and ending the deposition process after the coated thin silicon rod (1.2) has reached a predetermined thickness.

14. Method according to Claim 13, **characterized in that** the intervals are ≥ zero.

15. Method according to Claims 13 and 14, **characterized in that** a plurality of thin silicon rods (1.1) are selected and measured, staggered in time.

16. Method according to one of Claims 13 to 15, **characterized in that** reflections on the inner wall of the silicon deposition reactor before the start of the scanning process are masked out by a polarization filter.

## Patentansprüche

1. Anordnung zum Messen der Temperatur und des Dickenwachstums von Siliziumstäben in einem Siliziumabscheidungsreaktor durch ein Sichtfenster, **dadurch gekennzeichnet, dass** eine kontaktlose Betriebstemperaturmessvorrichtung (4) für die Temperaturmessung vorgesehen und außerhalb des Siliziumabscheidungsreaktors vor dem Sichtfenster (2) angeordnet ist, dass die Temperaturmessvorrichtung (4) sich horizontal um eine Schwenkachse (5) mittels eines Rotationsantriebs (9) dreht, wobei die Schwenkachse (5) parallel zur Längsachse des Siliziumstabs (1) verläuft und wobei die Mittelachse (6) der Temperaturmessvorrichtung durch die Schwenkachse (5) verläuft.

2. Anordnung nach Anspruch 1, **dadurch gekennzeichnet, dass** die Schwenkachse (5) außerhalb der Reaktorwand (3) des Siliziumabscheidungsreaktors, vor dem Sichtfenster (2), angeordnet ist.

3. Anordnung nach Anspruch 1, **dadurch gekennzeichnet, dass** die Schwenkachse (5) innerhalb des Siliziumabscheidungsreaktors, hinter dem Sichtfenster (2), angeordnet ist.

4. Anordnung nach einem der Ansprüche 1 bis 3, **dadurch gekennzeichnet, dass** das Sichtfenster (2) gekühlt ist.

5. Anordnung nach Anspruch 4, **dadurch gekennzeichnet, dass** das Sichtfenster (2) mit einer Flüssigkeitskühlung versehen ist.

6. Anordnung nach einem der Ansprüche 1 bis 5, **dadurch gekennzeichnet, dass** ein drehbares Polarisationsfilter (2.1) zwischen der Temperaturmessvorrichtung (4) und dem Sichtfenster (2) angeordnet ist.

7. Anordnung nach einem der Ansprüche 1 bis 6, **dadurch gekennzeichnet, dass** die Temperaturmessvorrichtung (4) ein Pyrometer ist.

8. Anordnung nach Anspruch 7, **dadurch gekennzeichnet, dass** die Messdaten des Pyrometers in einem Speicher gespeichert und auf einem Monitor angezeigt werden.

9. Anordnung nach Anspruch 8, **dadurch gekennzeichnet, dass** ein Raster über die Daten gelegt wird, die auf dem Monitor angezeigt werden.

10. Anordnung nach einem der Ansprüche 1 bis 6, **dadurch gekennzeichnet, dass** die Temperaturmessvorrichtung (4) eine Wärmebildkamera ist.

11. Anordnung nach einem der Ansprüche 1 bis 10, **dadurch gekennzeichnet, dass** die Temperaturmessvorrichtung (4) mit einem Rotationsantrieb (9) hinter dem Sichtfenster (2) verbunden ist, um die Schwenkachse (5) zu positionieren, wobei der Rotationsantrieb (9) sich unterhalb des Sichtfensters (2) befindet, wobei das Sichtfenster (2) in einem rohrförmigen Verbindungsstück (8) angeordnet ist, welches sich auf der Reaktorwand (3) befindet.

12. Verwendung der Anordnung nach einem der Ansprüche 1 bis 10 für Siliziumabscheidungsreaktoren.

13. Verfahren zum Messen der Temperatur und des Dickenwachstums von dünnen Siliziumstäben in einem Siliziumabscheidungsreaktor, **gekennzeichnet durch**
- Anordnen von dünnen Siliziumstäben im Siliziumabscheidungsreaktor, Entfernen des Sauerstoffs und Beginnen des Abscheidungsprozesses **durch** Aufnahme der dünnen Siliziumstäbe (1.1) in eine elektrische Schaltung und Einleiten von Trichlorsilan,
- Abtasten der dünnen Siliziumstäbe (1.1) **durch** eine Temperaturmessvorrichtung (4), die sich außerhalb des Siliziumabscheidungsreaktors befindet, und Auswählen von einem der dünnen Siliziumstäbe (1.1) und Fokussieren der Temperaturmessvorrichtung auf den ausgewählten dünnen Siliziumstab (1.1),
- Aufzeichnen einer Temperaturkurve, die über der Zeit dargestellt wird, und gleichzeitige Messung des Dickenwachstums **durch** horizontales Drehen der Temperaturmessvorrichtung (4), bis eine plötzliche helle/dunkle Veränderung festgestellt wird, und Drehen der Temperaturmessvorrichtung (4) in der entgegengesetzten Drehrichtung, bis eine weitere plötzliche helle/dunkle Veränderung festgestellt wird,
- Berechnung des Durchmessers des beschichteten dünnen Siliziumstabs aus dem Drehwinkel und der Entfernung zwischen der Schwenkachse (5) und dem Siliziumstab (1), und
- Wiederholen der Messung des Dickenwachstums in vorgegebenen Intervallen, und Beenden des Abscheidungsprozesses, nachdem der beschichtete dünne Siliziumstab (1.2) eine vorgegebene Dicke erreicht hat.

14. Verfahren nach Anspruch 13, **dadurch gekennzeichnet, dass** die Intervalle ≥ null sind.

15. Verfahren nach den Ansprüchen 13 und 14, **dadurch gekennzeichnet, dass** mehrere dünne Siliziumstäbe (1.1) ausgewählt und zeitversetzt gemessen werden.

16. Verfahren nach einem der Ansprüche 13 bis 15, **dadurch gekennzeichnet, dass** Reflexionen auf der Innenwand des Siliziumabscheidungsreaktors vor dem Start des Abtastprozesses durch ein Polarisationsfilter ausgeblendet werden.

## Revendications

1. Montage pour la mesure de la température et de la croissance en épaisseur de barreaux de silicium dans un réacteur de dépôt de silicium à travers un hublot d'observation, **caractérisé en ce qu'**un dispositif de mesure de la température fonctionnant sans contact (4) est prévu pour la mesure de la température et est disposé à l'extérieur du réacteur de dépôt de silicium devant un hublot d'observation (2), et **en ce que** le dispositif de mesure de la température (4) pivote horizontalement autour d'un axe de pivotement (5) au moyen d'un entraînement rotatif (9), l'axe de pivotement (5) étant parallèle à l'axe longitudinal du barreau de silicium (1), et l'axe central (6) du dispositif de mesure de la température passant par l'axe de pivotement (5).

2. Montage selon la revendication 1, **caractérisé en ce que** l'axe de pivotement (5) est disposé à l'extérieur de la paroi de réacteur (3) du réacteur de dépôt de silicium, devant le hublot d'observation (2).

3. Montage selon la revendication 1, **caractérisé en ce que** l'axe de pivotement (5) est disposé à l'intérieur du réacteur de dépôt de silicium, derrière le hublot d'observation (2).

4. Montage selon l'une des revendications 1 à 3, **caractérisé en ce que** le hublot d'observation (2) est refroidi.

5. Montage selon la revendication 4, **caractérisé en ce que** le hublot d'observation (2) est pourvu d'un refroidissement par liquide.

6. Montage selon l'une des revendications 1 à 5, **caractérisé en ce qu'**un filtre de polarisation rotatif (2.1) est disposé entre le dispositif de mesure de la température (4) et le hublot d'observation (2).

7. Montage selon l'une des revendications 1 à 6, **caractérisé en ce que** le dispositif de mesure de la température (4) est un pyromètre.

8. Montage selon la revendication 7, **caractérisé en ce que** les données de mesure du pyromètre sont stockées dans une mémoire et sont affichées sur un moniteur.

9. Montage selon la revendication 8, **caractérisé en ce qu'**une grille est superposée sur les données affichées sur le moniteur.

10. Montage selon l'une des revendications 1 à 6, **caractérisé en ce que** le dispositif de mesure de la température (4) est une caméra thermique.

11. Montage selon l'une des revendications 1 à 10, **caractérisé en ce que** le dispositif de mesure de la température (4) est couplé à un entraînement rotatif (9) derrière le hublot (2) afin de positionner l'axe de pivotement (5), lequel entraînement rotatif (9) est situé en dessous du hublot (2), le hublot (2) étant disposé dans un raccord tubulaire (8) situé sur la paroi de réacteur (3).

12. Utilisation du montage selon l'une des revendications 1 à 10 pour des réacteurs de dépôt de silicium.

13. Procédé de mesure de la température et de la croissance en épaisseur de barreaux minces de silicium dans un réacteur de dépôt de silicium, **caractérisé par**
- la mise en place de barreaux minces de silicium dans le réacteur de dépôt de silicium, le retrait de l'oxygène et le démarrage du procédé de dépôt par intégration des barreaux minces de silicium (1.1) dans un circuit électrique et introduction de trichlorosilane,
- le balayage des barreaux minces de silicium (1.1) par un dispositif de mesure de la température (4) qui est situé à l'extérieur du réacteur de dépôt de silicium, la sélection de l'un des barreaux minces de silicium (1.1) et la focalisation du dispositif de mesure de la température sur le barreau mince de silicium (1.1) sélectionné,
- l'enregistrement d'une courbe de température tracée en fonction du temps et la mesure simultanée de la croissance en épaisseur par pivotement horizontal du dispositif de mesure de la température (4) jusqu'à ce qu'un changement brusque clair/sombre soit identifié et pivotement du dispositif de mesure de la température (4) dans la direction de pivotement opposée jusqu'à ce qu'un autre changement brusque clair/sombre soit identifié,
- le calcul du diamètre du barreau mince de silicium revêtu à partir de l'angle de pivotement et de la distance entre l'axe de pivotement (5) et le barreau de silicium (1), et
- la répétition de la mesure de la croissance en épaisseur à des intervalles prédéterminés, et l'achèvement du procédé de dépôt après que le barreau mince de silicium revêtu (1.2) a atteint une épaisseur prédéterminée.

14. Procédé selon la revendication 13, **caractérisé en ce que** les intervalles sont supérieurs ou égaux à zéro.

15. Procédé selon les revendications 13 et 14, **caractérisé en ce qu'**une pluralité de barreaux minces de silicium (1.1) est sélectionnée et mesurée, échelonnée dans le temps.

16. Procédé selon l'une des revendications 13 à 15, **caractérisé en ce que** les réflexions sur la paroi interne du réacteur de dépôt de silicium avant le démarrage du procédé de balayage sont masquées par un filtre de polarisation.
